Europäisches Patentamt

European Patent Office

Office européen des brevets

(11) Veröffentlichungsnummer: **0 400 178 B1**

## (12) EUROPÄISCHE PATENTSCHRIFT

(45) Veröffentlichungstag der Patentschrift: **03.08.94**

(51) Int. Cl.⁵: **H01L 23/29**

(21) Anmeldenummer: **89109837.8**

(22) Anmeldetag: **31.05.89**

Die Akte enthält technische Angaben, die nach dem Eingang der Anmeldung eingereicht wurden und die nicht in dieser Patentschrift enthalten sind.

(54) **Halbleiterbauelement mit Passivierungsschicht.**

(43) Veröffentlichungstag der Anmeldung:
**05.12.90 Patentblatt 90/49**

(45) Bekanntmachung des Hinweises auf die Patenterteilung:
**03.08.94 Patentblatt 94/31**

(84) Benannte Vertragsstaaten:
**CH DE LI SE**

(56) Entgegenhaltungen:
**EP-A- 0 008 406**
**EP-A- 0 019 887**
**EP-A- 0 075 892**
**GB-A- 1 566 072**

**IEEE TRANSACTIONS ON ELECTRON DEVI- CES, Band ED-26, Nr. 11, November 1979, Seiten 1728-1734, IEEE, New York, US; M.L. TARNG et al.: " Passivation of p-n junction in crystalline silicon by amorphous silicon"**

**APPLIED PHYSICS LETTERS 44(1984) June, no. 11, New York USA, pages 1092-1094: "High performance hydrogenated amorp- hous Si solar cells with graded boron-doped intrinsic layers prepared from disilane at high deposition rates", T. Matsushita et al.**

(73) Patentinhaber: **SIEMENS AKTIENGESELL- SCHAFT**
**Wittelsbacherplatz 2**
**D-80333 München(DE)**

(72) Erfinder: **Schmidt, Gerhard, Dr. Dipl.-Phys.**
**Karl-Bröger-Strasse 28**
**D-8550 Forchheim(DE)**

## Beschreibung

Die Erfindung bezieht sich auf ein Halbleiterbauelement mit einem Halbleiterkörper mit mehreren aufeinanderfolgenden Zonen abwechselnden Leitungstyps, mit an die Oberfläche des Halbleiterkörpers tretenden pn-Übergängen und mit einer aus einem amorphen Halbleitermaterial bestehenden Passivierungsschicht.

Ein solches Halbleiterbauelement ist z. B. in der DE-OS 27 30 367 beschrieben worden. Das amorphe Halbleitermaterial ist Silizium, das im Vakuum bei geringem Restdruck wenigstens dort auf die Oberfläche des kristallinen Halbleiterkörpers aufgedampft wird, wo die pn-Übergänge an die Oberfläche treten. Anschließend wird die Passivierungsschicht getempert. Halbleiterbauelemente mit derart passivierten Halbleiterkörpern zeigen eine ausreichende Stabilität der Sperrstromkennlinien bis zu einer Spannung von etwa 4 kV.

Ein solches Halbleiterbauelement ist auch aus EP-A-0 008 406 bekannt, wobei die Passivierungsschicht aus Bordotierten amorphen Silizium besteht.

Für höhere Sperrspannungen von über 4 kV vorgesehene Halbleiterbauelemente wie Thyristoren und Planardioden lassen sich mit der beschriebenen Schicht nicht befriedigend passivieren, da bei diesen Spannungen die Sperrfähigkeit durch die genannte Passivierungsschicht abnimmt. Dies ist auf die Ausbildung von Inversionsschichten an der Oberfläche des Halbleiterkörpers und/oder auf Oberflächendurchbruch durch zu hohe Oberflächenfeldstärken zurückzuführen. Es ist jedoch wünschenswert, zur Passivierung ein Halbleitermaterial zu verwenden, da dies wegen seiner hohen Defektdichte im Gegensatz zum Isolator den Vorteil hat, den aktiven Bauelementebereich elektrisch abzuschirmen. Nur mit einer solchen Passivierung lassen sich Oberflächenladungen neutralisieren.

Der Erfindung liegt die Aufgabe zugrunde, eine Passivierungsschicht der obengenannten Art so weiterzubilden, daß sie auch für Bauelemente mit üblicher Randkontur verwendet werden kann, die mit Blockierspannungen und Sperrspannungen größer als 4 kV betrieben werden sollen. Diese Aufgabe wird dadurch gelöst, daß das amorphe Halbleitermaterial folgenden Bedingungen genügt:

a) $j_0/\sigma > d \left(\frac{dE}{dx}\right)_{max}$

b)

$$V_n^b \leq E_g/2, \quad V_p^b \leq E_g/2,$$

wobei $j_0$ die Sperrstromdichte des amorph-kristallinen Hetero-Übergangs, $\sigma$ und $d$ die spezifische Leitfähigkeit bzw. die Dicke der amorphen Schicht, $\left(\frac{dE}{dx}\right)_{max}$ der maximale Feldgradient an der Oberfläche des sperrgepolten Halbleiterbauelements,

$$V_{n,p}^b$$

die um das Oberflächenpotential in der amorphen Schicht reduzierte Barrierenhöhe und $E_g$ der Bandabstand im kristallinen Halbleiterkörper ist.

Besteht die Passivierungsschicht aus im Vakuum aufgedampftem und anschließend getempertem Silizium, so werden beide Bedingungen dadurch erfüllt, daß das amorphe Silizium mit einer Konzentration von $10^{19}\,cm^{-3}$ bis $10^{20}\,cm^{-3}$, vorzugsweise mit $2 \times 10^{19}\,cm^{-3}$ dotiert wird. Durch diese Dotierung wird nämlich die spezifische Leitfähigkeit $\sigma$ verringert und das Verhältnis $j_0/\sigma$ vergrößert. Außerdem wird durch die Dotierung das Ferminiveau derart verschoben, daß das Merkmal b) erfüllt ist.

Durch die genannte Dotierung ist die Anzahl der donatorartigen Zustände im amorphen Silizium der Anzahl seiner akzeptorartigen Zustände etwa annähernd gleich.

Die Erfindung wird anhand eines Ausführungsbeispiels in Verbindung mit den FIG 1 bis 4 näher erläutert. Es zeigen FIG 1 und 2 schematische Darstellungen zur Erläuterung der Bedingung a) zur Verhinderung des Durchbruchs FIG 3 eine schematische Darstellung des Bändermodells zur Erläuterung der Bedingung b) zur Verhinderung der Inversion und FIG 4 einen teilweisen Schnitt durch einen passivierten Halbleiterkörper mit einer Passivierungsschicht gemäß der Erfindung.

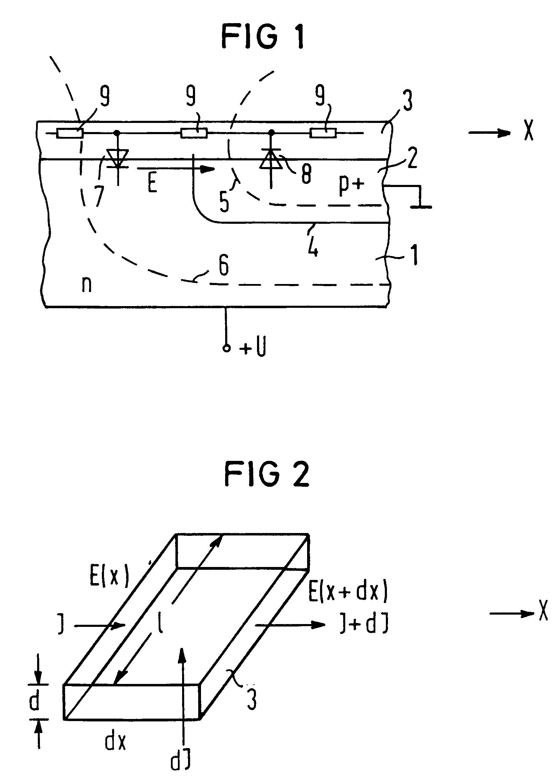

In FIG 1 ist schematisch ein teilweiser Schnitt durch eine Planardiode dargestellt. Diese hat ein n-leitendes Substrat 1, in das eine $p^+$-dotierte Zone 2 eingebettet ist. Die Oberfläche des Substrats und der Zone 2 ist mit einer Passivierungsschicht 3 bedeckt, die aus einem amorphen Halbleitermaterial, z. B. aus im Hochvakuum aufgedampften Silizium besteht. Zwischen Substrat 1 und Zone 2 liegt ein pn-Übergang 4. Dieser wird durch eine an das Substrat 1 gelegte Spannung $+U$ in Sperrichtung vorgespannt, wenn die Zone 2 auf Massepotential liegt. Damit spannt sich eine Raumladungszone auf, die den durch die gestrichelten Linien 5, 6 begrenzten Verlauf hat. Die Lateralkomponente der Feldstärke an der Oberfläche des Halbleiterkörpers ist durch den nach rechts gerichteten Pfeil E charakterisiert. Die amorphe Schicht 3 bildet mit dem kristallinen Halbleiterkörper Hetero-Übergänge, die zwischen Substrat 1 und Schicht 3 durch eine Diode 7 und zwischen Zone 2 und Schicht 3 durch eine Diode 8 symbolisiert sind. Die Schicht 3 selbst hat eine spezifische Leitfähigkeit, die durch die Serienwiderstände 9 symbolisiert ist. Diese Widerstände liegen zwischen der Anode der Diode 7 und der Katode der Diode 8. Die Dioden und die Widerstände sind hier, wie erwähnt, nur symbolisch dargestellt, in Wirklichkeit wird der Hetero-Übergang durch unendlich viele, fein verteilte Dioden und Widerstände gebildet.

In FIG 2 ist ein Flächenelement der amorphen Schicht 3 dargestellt. Es hat eine Dicke d, eine Breite 1 und eine Länge dx. Der lateral von links in das Flächenelement fließende Strom ist mit I bezeichnet. Der aus dem Halbleiterkörper stammende Stromanteil ist dI, der rechts aus dem Flächenelement austretende Strom demnach $I+dI$. Die zum linken Rand des Flächenelements gehörende Feldstärke ist E(x). Entsprechend ist die Feldstärke am rechten Rand $E(x + dx)$ und die Feldstärkeänderung über dem Flächenelement dE(x).

Um einen Durchbruch des amorph-kristallinen Heteroübergangs zu verhindern, muß die Bedingung

$$j_0/\sigma > d \left(\frac{dE}{dx}\right)_{max}$$

erfüllt sein. Dabei ist $j_0$ die Sperrstromdichte des erwähnten Heteroübergangs, $\sigma$ die spezifische Leitfähigkeit der amorphen Schicht 3, $\left(\frac{dE}{dx}\right)_{max}$ der maximale Feldgradient an der Oberfläche der sperrgepolten aus Substrat 1 und Zone 2 bestehenden Diode und d die Dicke der amorphen Schicht.

Die spezifische Leitfähigkeit $\sigma$ der amorphen Schicht 3 läßt sich durch Dotierung derart verringern, daß das Verhältnis $j_0/\sigma$ größer als $d\left(\frac{dE}{dx}\right)_{max}$ wird. Hiermit läßt sich ein unzulässig hoher, zum Durchbruch führender Spannungsabfall am Heteroübergang zwischen der amorphen Passivierungsschicht und dem kristallinen Silizium des Halbleiterkörpers vermeiden.

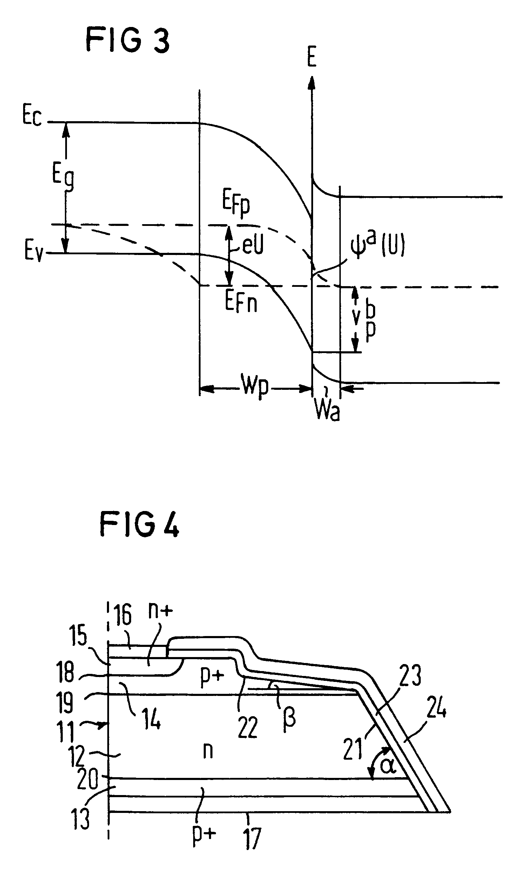

Neben der Forderung, einen Durchbruch des Heteroübergangs zur vermeiden, muß auch die Forderung erfüllt werden, Inversionsschichten zu verhindern. Zur Erläuterung dient das Bändermodell nach FIG 3. Das Leitungsband ist mit $E_c$, das Valenzband mit $E_v$, das verbotene Band mit $E_g$ bezeichnet. Die Quasi-Fermi-Niveaus des sperrgepolten amorph-kristallinen Heteroübergangs sind mit $E_{Fp}$ und $E_{Fn}$ bezeichnet.

Wenn die Inversion verhindert werden soll, gilt auf einem p-dotiertem Substrat die Beziehung

$$E_c - E_{Fn} \geq \frac{E_g}{2}$$

Das ist gleichbedeutend mit

$$V_p^b \leq \frac{E_g}{2}$$

$$V_p^b = V_{0p}^b - \psi_p^a$$

$$V_p^b = V_{0p}^b - \psi_p^a \leq \frac{E_g}{2}$$

Hier ist $V_p^b$ die effektive Barrierenhöhe des Heteroübergangs auf einem p-Substrat, $V_{0p}^b$ die Barrierenhöhe und $\psi_p^a$ das Oberflächenpotential im amorphen Silizium auf p-Substrat. Über dem n-dotierten Substrat ergibt sich analog

$$V_n^b = V_{0n}^b - \psi_n^a \leq \frac{E_g}{2}.$$

Weiterhin gilt die Bedingung

$$V_{0n}^b + V_{0p}^b = E_g.$$

Beim amorphen Aufdampfsilizium ist nun die Zustandsdichte hoch und das Oberflächenpotential $\psi^a$ klein. Es liegt in der Größenordnung 0,1 eV. Es ist daher erforderlich, daß die genannten Barrierenhöhen etwa gleich groß werden:

$$V_{0n}^b \approx V_{0p}^b \approx \frac{E_g}{2}.$$

Die Barrierehöhen dürfen sich also nur um den Betrag $\psi^a$ von

$$\frac{E_g}{2}$$

unterscheiden und werden durch entsprechende Dotierung des amorphen Siliziums eingestellt. Durch die erwähnte Bor-Dotierungskonzentration von $10^{19}$- $10^{20}$ cm$^{-3}$, vorzugsweise $2 \times 10^{19}$ cm$^{-3}$ wird das Femi-Niveau um etwa 0,1 eV verschoben. Die Barrierenhöhen betragen beim nicht kompensierten amorphen Silzium

$$V_{0n}^b = 0,36 \text{ eV}$$

und

$$V_{0p}^b = 0,76 \text{ eV}.$$

Beim p-dotierten, kompensierten amorphen Silzium betragen die Barrierenhöhen

$$V_{0n}^b = 0,46 \text{ eV}$$

und

$$V_{0p}^b = 0,66 \text{ eV}.$$

Da, wie oben erwähnt, beim getemperten amorphen Aufdampfsilizium das Kontaktpotential $\psi_p^a$ und $\psi_n^a$ in der Größenordnung von 0,1 eV liegt, wird die Inversionsbedingung unterdrückt:

$$V_p^b = 0,66 \text{ eV} - 0,1 \text{ eV} = 0,56 \text{ eV} < \frac{E_g}{2}$$

$$V_n^b = 0,46 \text{ eV} - 0,1 \text{ eV} = 0,36 \text{ eV} < \frac{E_g}{2}.$$

Das Ausführungsbeispiel nach FIG 4 ist ein Thyristor mit einem Halbleiterkörper 11, der zu einer gestrichelt eingezeichneten Achse rotationssymmetrisch ist. Der Halbleiterkörper hat eine n-dotierte Innenzone 12, an die sich an der Katodenseite eine stark p-dotierte Katodenbasiszone 14 und an der Anodenseite eine stark p-dotierte Anodenzone 13 anschließt. In der Zone 14 ist eine Katodenemitterzone 15 planar eingebettet. Zwischen den Zonen 14 und 15 liegt ein pn-Übergang 18, zwischen den Zonen 12 und 14 ein pn-Übergang 19 und zwischen den Zonen 12 und 13 ein pn-Übergang 20. Die Katodenemitterzone 15 ist mit einer Katodenelektrode 16, die Anodenzone 13 ist mit einer Anodenelektrode 17 kontaktiert.

Der Halbleiterkörper hat eine herkömmliche Randstruktur, d. h. der Winkel $\alpha$ zwischen dem pn-Übergang 20 und einer ersten Randfläche 21 der Zone 12 ist positiv und der Winkel $\beta$ zwischen einer Parallele zum pn-Übergang 19 und einer zweiten Randfläche 22 der Zone 14 ist negativ. Dieser Winkel ist klein und liegt in der Größenordnung von einigen Grad.

Der Halbleiterkörper 11 ist dort, wo die pn-Übergänge 18, 19 und 20 an seine Oberfläche treten, mit einer Passivierungsschicht 23 bedeckt. Diese Passivierungsschicht besteht z. B. aus aufgedampftem, amorphem Silizium, das mit Bor in einer Dotierungskonzentration von $10^{19}\,cm^{-3}$ bis $10^{20}\,cm^{-3}$, vorzugsweise $2 \times 10^{19}\,cm^{-3}$ dotiert ist. Bei einer Dotierung in dieser Höhe sind die donatorartigen Zustände des amorphen Siliziums wenigstens annähernd ausgeglichen. Die aufgedampfte Schicht kann eine Dicke von 100 nm haben. Sie wird nach Ätzen der Randkontur des Halbleiterkörpers in einer Hochvakuumanlage durch Elektronenstrahlverdampfung bei einem Restgasdruck von etwa $10^{-7}$ mb mit einer Rate von 0,2 nm/s bei einer Substrattemperatur von etwa 200° C aufgedampft. Anschließend wird sie etwa 10 Stunden bei ungefähr 340° C getempert. Die Schicht kann in Stickstoff $N_2$, Luft oder im Vakuum getempert werden. Eine derart aufgedampfte amorphe Siliziumschicht würde nach dem Tempern ohne p-Dotierung eine ausgeprägte n-Leitfähigkeit aufweisen. Dies würde daher im Bereich der p-dotierten Zone 14 zur Inversion führen, was sich in einer Abnahme der Blockierspannung des Thyristors niederschlägt. Die n-Dotierung wird dadurch erreicht, daß dem zu verdampfenden Silizium-Ausgangsmaterial eine Borkonzentration von $10^{19}$ bis $10^{20}\,cm^{-3}$ zugefügt wird.

Auf die gemäß dem obenangegebenen Verfahren hergestellte Passivierungsschicht 23 wird dann zum mechanischen Schutz eine Schutzschicht 24 aufgebracht, die z. B. aus Silikonkautschuk besteht. Diese Schicht braucht keine die elektrischen Verhältnisse der Oberfläche des Halbleiterkörpers beeinflussenden Ladungsträger zu enthalten.

Bei entsprechender Dimensionierung und an sich bekannter, in FIG 4 dargestellter Randflächenkonturierung lassen sich Halbleiterbauelemente mit einer Blockierspannung bzw. Sperrspannung von 6 kV langzeitstabil passivieren.

Anstelle des aufgedampften amorphen Siliziums lassen sich auch andere Halbleiter, wie z. B. aufgesputtertes Silizium, amorphes SiC oder aC:H (amorpher wasserstoffhaltiger Kohlenstoff) verwenden. Andere als in Flg 1 gezeigte Randkonturen und Bauelemente, z. B. Planardioden, lassen sich ebenfalls passivieren. Die genannten Stoffe zeichnen sich wie das amorphe Silizium durch eine hohe Dichte umladbarer Zustände und damit durch eine gute Abschirmwirkung aus. Die Schichten sind auch mit dem Herstellungsprozeß der Bauelemente kompatibel. Sie weisen auch eine nur geringe spezifische Leitfähigkeit auf, so daß die parasitären Sperrströme in der Passivierungsschicht klein gegen die Sperrströme des Bauelements bleiben.

**Patentansprüche**

1. Halbleiterbauelement mit einem kristallinen Halbleiterkörper (11) mit mehreren aufeinanderfolgenden Zonen (15, 14, 12, 13) abwechselnden Leitungstyps, mit an die Oberfläche des Halbleiterkörpers tretenden pn-Übergängen (18, 19, 20) und mit einer aus einem amorphen Halbleitermaterial bestehenden Passivierungsschicht (23), **dadurch gekennzeichnet,** daß das amorphe Halbleitermaterial folgenden Bedingungen genügt:

a) $j_0/\sigma > d \left(\frac{dE}{dx}\right)_{max}$

b)

$$v_n^b \leq E_g/2, \quad v_p^b \leq E_g/2,$$

wobei $j_0$ die Sperrstromdichte des amorph-kristallinen Hetero-Übergangs, $\sigma$ und $d$ die spezifische Leitfähigkeit bzw. die Dicke der amorphen Schicht, $\left(\frac{dE}{dx}\right)_{max}$ der maximale Feldgradient an der Oberfläche des sperrgepolten Halbleiterbauelements,

EP 0 400 178 B1

$$V_{n,p}^{b}$$

die um das Oberflächenpotential in der amorphen Schicht reduzierte Barrierenhöhe und $E_g$ der Bandabstand im kristallinen Halbleiterkörper ist.

2. Halbleiterbauelement nach Anspruch 1,
**dadurch gekennzeichnet,** daß das amorphe Halbleitermaterial derart dotiert ist, daß die Anzahl seiner donatorartigen Zustände der Anzahl seiner aktezeptorartigen Zustände wenigstens annähernd gleich ist.

3. Halbleiterbauelement nach Anspruch 1 oder 2
mit einer aus amorphen Silizium bestehenden Passivierungsschicht, **dadurch gekennzeichnet,** daß das amorphe Silizium mit Bor mit einer Konzentration von $10^{19}$- $10^{20}\,cm^{-3}$ dotiert ist.

4. Halbleiterbauelement nach Anspruch 3,
**dadurch gekennzeichnet,** daß die Konzentration $2 \times 10^{19}\,cm^{-3}$ beträgt.

5. Halbleiterbauelement nach Anspruch 1 oder 2,
**dadurch gekennzeichnet,** daß das amorphe Halbleitermaterial Siliziumcarbid (SiC) ist.

6. Halbleiterbauelement nach Anspruch 1 oder 2,
**dadurch gekennzeichnet,** daß das amorphe Halbleitermaterial wasserstoffhaltiger Kohlenstoff (a-C:H) ist.

**Claims**

1. Semiconductor device having a crystalline semi-conductor body (11) with a plurality of successive zones (15, 14, 12, 13) of alternating conduction type, having pn junctions (18, 19, 20) coming to the surface of the semiconductor body, and having a passivation layer (23) comprising an amorphous semiconductor material, characterized in that the amorphous semiconductor material satisfies the following conditions:
   a) $j_0/\sigma > d \left(\frac{dE}{dx}\right)_{max}$
   b)

$$V_{n}^{b} \leq E_{g}/2, \quad V_{p}^{b} \leq E_{g}/2,$$

$j_0$ being the reverse current density of the amorphous crystalline heterojunction, $\sigma$ and $d$ being respectively the specific conductance and the thickness of amorphous layer, $\left(\frac{dE}{dx}\right)_{max}$ being the maximum field gradient at the surface of the semiconductor device connected in the reverse direction,

$$V_{n,p}^{b}$$

being the barrier height reduced by the surface potential in the amorphous layer, and $E_g$ being the energy gap in the crystalline semiconductor body.

2. Semiconductor device according to Claim 1, characterized in that the amorphous semiconductor material is doped in such a way that the number of its donor-type states is at least approximately equal to the number of its acceptor-types states.

3. Semiconductor device according to Claim 1 or 2, having a passivation layer comprising amorphous silicon, characterized in that the amorphous silicon is doped with boron at a concentration of $10^{19}$-$10^{20}$ $cm^{-3}$.

6

4. Semiconductor device according to Claim 3, characterized in that the concentration is 2 x 10$^{19}$ cm$^{-3}$.

5. Semiconductor device according to Claim 1 or 2, characterized in that the amorphous semiconductor material is silicon carbide (SiC).

6. Semiconductor device according to Claim 1 or 2, characterized in that the amorphous semiconductor material is hydrogen-containing carbon (a C:H).

**Revendications**

1. Composant à semiconducteurs comportant un corps semiconducteur cristallin (11) possédant plusieurs zones successives (15, 14, 12, 13) à types de conductivité alternés, des jonctions pn (18,19,20) apparaissant à la surface du corps semiconducteur, et une couche de passivation (23) en un matériau semiconducteur amorphe, caractérisé par le fait que le matériau semiconducteur amorphe satisfait aux conditions suivantes :

   a) $j_0/\sigma > d\left(\frac{dE}{dx}\right)_{max}$

   b) $V_n^b \leq E_g/2$, $V_p^b \leq E_g/2$,

   $j_0$ représentant la densité de courant de blocage de l'hétérojonction amorphe-cristalline, $\sigma$ et d la conductivité spécifique et l'épaisseur de la couche amorphe, $\left(\frac{dE}{dx}\right)_{max}$ le gradient de champ maximum à la surface du composant semiconducteur polarisé en inverse, $V_{n,p}^b$ la hauteur de la barrière, réduite du potentiel de surface, dans la couche amorphe, et $E_g$ l'intervalle d'énergie entre bandes dans le corps semiconducteur cristallin.

2. Composant à semiconducteurs suivant la revendication 1, caractérisé par le fait que le matériau semiconducteur amorphe est dopé de telle sorte que le nombre de ses états de type donneurs est au moins approximativement égal au nombre de ces états de type accepteurs.

3. Composant à semiconducteurs suivant la revendication 1 ou 2, comportant une couche de passivation constituée par du silicium amorphe, caractérisé par le fait que le silicium amorphe est dopé par du bore présent en une concentration égale à 10$^{19}$-10$^{20}$ cm$^{-3}$.

4. Composant à semiconducteurs suivant la revendication 3, caractérisé par le fait que la concentration est égale à 2 x 10$^{19}$ cm$^{-3}$.

5. Composant à semiconducteurs suivant la revendication 1 ou 2, caractérisé par le fait que le matériau semiconducteur amorphe est du carbure de silicium (SiC).

6. Composant à semiconducteurs suivant la revendication 1 ou 2, caractérisé par le fait que le matériau semiconducteur amorphe est du carbone hydrogéné (a-C:H).

# FIG 1

# FIG 2

## FIG 3

## FIG 4